# EUROPEAN PATENT SPECIFICATION

(11) **EP 3 343 655 B1**
(45) Date of publication and mention of the grant of the patent: **02.03.2022**
(21) Application number: 16207339.9
(22) Date of filing: 29.12.2016
(51) Int. Cl.: H01L 43/08, H01L 43/12

(54) **MAGNETIC TUNNEL JUNCTION DEVICE**
MAGNETISCHES TUNNELKONTAKTELEMENT
DISPOSITIF DE JONCTION DE TUNNEL MAGNÉTIQUE

(43) Date of publication of application: 04.07.2018
(73) Proprietor: IMEC VZW, 3001 Leuven (BE)
(72) Inventor: GARELLO, Kevin, 3001 Leuven (BE); RAO, Siddharth, 3001 Leuven (BE)
(74) Representative: AWA Sweden AB

(56) References cited:
- JP-A- 2009 290 050
- US-A1- 2014 080 227
- JUNE W LAU ET AL: "TOPICAL REVIEW;Magnetic nanostructures for advanced technologies: fabrication, metrology and challenges;Topical Review", JOURNAL OF PHYSICS D: APPLIED PHYSICS, INSTITUTE OF PHYSICS PUBLISHING LTD, GB, vol. 44, no. 30, 7 July 2011 (2011-07-07), page 303001, XP020208131, ISSN: 0022-3727, DOI: 10.1088/0022-3727/44/30/303001

## Description

### Technical field

The present invention generally relates to the field of memory devices. More specifically, the present invention relates to a magnetic tunnel junction (MTJ) device, and a method of forming a MTJ device.

### Background

There is a considerable interest in using spintronics in order to develop nonvolatile magnetic memories (MRAMs). Advanced MRAM devices comprise magnetic tunnel junctions (MTJs) which comprise two ferromagnetic (FM) layers separated by an insulating layer. If the insulating layer is thin enough, typically a few nanometers, electrons can tunnel from one ferromagnetic layer into the other. The resistance of the MTJ is dependent on the relative orientation of the two ferromagnetic layers. This mechanism is known as tunnel magnetoresistance (TMR).

In an MTJ, the reading operation is operated by the TMR. The writing operation can be achieved by spin-transfer torque (STT), representing a transfer of spin angular momentum from a reference FM layer to a free FM layer of the MTJ. These STT-MRAM devices are often called two-terminal devices, as the STT-writing use the same path as the TMR reading. Recently, increasing attention has been paid to three-terminal MTJs which decouple the writing and reading path and which may allow for a relatively high operation speed and a more resistant (endurable) device with respect to STT-MTJ. In this concept, the switching of the magnetization in the free FM layer can be mediated by spin-orbit torques (SOTs) which may be generated by conducting a current through a layer arranged adjacently the free FM layer. Based on recent studies, the concept of SOT-MRAM seems promising for providing relatively fast applications.

However, it should be noted that the SOT concept requires an application of an external field in the plane of the MTJ and along the SOT current direction in order to break the symmetry of the system and to obtain a deterministic magnetization switching. Hence, there is a wish to provide a SOT-MTJ element which is switchable without the need of providing an external field.

JP2009-290050 A is related to a magnetorestrictive element having a configuration and a structure where a disturb phenomenon caused by a neighboring spin injection type magnetorestrictive element hardly occurs (abstract).

### Summary of the inventive concept

It is an object of the present invention to mitigate the above-mentioned problems, and to provide an efficient SOT-MTJ device.

This and other objects are achieved by providing MTJ devices and methods of forming such MTJ devices having the features in the independent claims. Preferred embodiments are defined in the dependent claims.

Hence, according to a first aspect of the present invention, there is provided a method for forming a magnetic tunnel junction, MTJ, device. The method comprises providing a stack of layers comprising, in a top-down direction, a first magnetic layer having a fixed magnetization direction, a barrier layer, and a second magnetic layer being configured to switch its magnetization direction with respect to the fixed magnetization direction of the first magnetic layer. The method further comprises etching the stack of layers such that a pillar is formed and such that at least one trench is created in the second magnetic layer adjacent the pillar. The method further comprises processing of at least one region of the second magnetic layer peripheral of the at least one trench with respect to the pillar, such that the at least one region obtains an in-plane magnetic anisotropy.

According to a second aspect of the present invention, there is provided an alternative method for forming a MTJ device. The method comprises providing a stack of layers, at least comprising, in a top-down direction, a first magnetic layer having a fixed magnetization direction, a barrier layer, and a second magnetic layer being configured to switch its magnetization direction with respect to the fixed magnetization direction of the first magnetic layer. The stack of layers further includes a pinning layer arranged above the first magnetic layer for fixing the magnetization direction of the first magnetic layer. The method further comprises etching the stack of layers, at least until the first magnetic layer to form a pillar. The method further comprises processing a portion of the second magnetic layer extending outside said pillar as viewed in a horizontal plane, such that the portion obtains an in-plane magnetic anisotropy. Moreover, the method comprises de-magnetizing, of the portion of the second magnetic layer, at least one region located adjacent the pillar, as viewed in a horizontal plane. Thereby, a de-magnetized region of the second magnetic layer, located adjacent to the pillar, and a portion of the second magnetic layer, peripheral of the de-magnetized region, having an in-plane magnetic anisotropy are formed. By the term "horizontal plane" is here meant a plane parallel to a main surface or main plane of extension of the second magnetic layer. By the term "de-magnetizing", it is here meant that the portion or region subjected to the de-magnetization becomes non-magnetic or substantially non-magnetic in non-reversible manner. According to an alternative method, the last two steps after the etching step may be reversed. In other words, after the etching, there may be provided the step of de-magnetizing, of the portion of the second magnetic layer, at least one region located adjacent the pillar, and thereafter, a processing of the portion of the second magnetic layer such that the portion obtains an in-plane magnetic anisotropy.

According to a third aspect of the present invention, there is provided a MTJ device comprising a stack of layers, at least comprising, in a top-down direction, a first magnetic layer having a fixed magnetization direction, a barrier layer, and a second magnetic layer being configured to switch its magnetization direction with respect to the fixed magnetization direction of the first magnetic layer. At least the first magnetic layer, and, optionally, the barrier layer may constitute a pillar, and a portion of the second magnetic layer extends from the pillar in a horizontal plane. At least one first region of the portion of the second magnetic layer comprises at least one trench adjacent the pillar. Furthermore, of the portion of the second magnetic layer, at least one second region peripheral of the at least one trench with respect to the pillar, have an in-plane magnetic anisotropy.

According to a fourth aspect of the present invention, there is provided a MTJ device, comprising a stack of layers, at least comprising, in a top-down direction, a first magnetic layer having a fixed magnetization direction, a barrier layer, and a second magnetic layer being configured to switch its magnetization direction with respect to the fixed magnetization direction of the first magnetic layer. The stack of layers further includes a pinning layer arranged above the first magnetic layer for fixing the magnetization direction of the first magnetic layer. At least said pinning layer, and optionally, the first magnetic layer, and optionally, the barrier layer, constitutes a pillar. The second magnetic layer comprises at least one first portion located outside (and adjacent) the pillar, as viewed in a horizontal plane, wherein the at least one first portion is de-magnetized. The second magnetic layer comprises at least one second portion located peripheral of the at least one first portion with respect to the pillar, wherein the at least one second portion has an in-plane magnetic anisotropy.

Thus, the present invention is based on the idea of providing field-free switching in (SOT)-MTJ devices and/or methods of forming such MTJ devices. To realize this concept, the second magnetic (free) layer of the MTJ stack comprises an inner portion having an out-of-plane magnetic anisotropy and at least one outer portion having an in-plane magnetic anisotropy. The inner and outer portions of the second magnetic layer are (physically) separated by from each other, either by a trench or a de-magnetized region. It will be appreciated that in the case of providing a continuous second magnetic layer, i.e. without any trench or de-magnetized region, there is a spin-to-spin coupling between the magnetizations of the inner portion and the outer portion. It will be appreciated that this coupling generates relatively complex magnetization dynamics. More specifically, the coupling is accompanied by an in-plane to out-of-plane magnetic transition, and it generates relatively complex magnetization dynamics of both the inner and outer portion of the second magnetic layer. As a consequence, the switching is relatively difficult to control. Although it is still possible to deterministically control the magnetization by providing a continuous second magnetic layer, it should be noted that the magnetization is relatively sensitive with regard to several parameters of the SOT (e.g. the amplitude, the ratio between field-like and damping-like components, the strength of the Dzyaloshinskii-Moriya interaction, the part of the outer portion being exposed to the SOT current, etc.). In contrast, by providing a magnetic separation in the second magnetic layer, according to the present invention, the control of the switching is improved. It will be appreciated that the level of control of the switching according to the present invention may be comparable to that of SOT switching by means of an external field.

It will be appreciated that the second magnetic (free) layer is already a part of the MTJ stack, and the present invention is thereby advantageous in that an adding of auxiliary layers, which could complicate the method of the creating the MTJ device, may be superfluous. The present invention is furthermore advantageous in that the properties of an underlying SOT-generating layer of the stack may be chosen in a relatively unrestricted manner. For example, a SOT-generating layer may be provided which generates relatively large SOTs. Moreover, the present invention is advantageous in that the anisotropy of the second magnetic layer may be controlled and/or tuned to a relatively high extent.

It should be noted that mentioned advantages of the method(s) of the first and/or second aspects of the present invention also hold for the MTJ device(s) according to the third and/or fourth aspects of the present invention.

According to an embodiment of the present invention, the step of etching further comprises etching the stack of layers until the second magnetic layer to form a pillar, whereby a portion of the second magnetic layer extends from the pillar in a horizontal plane. The step further comprises patterning the portion of the second magnetic layer and, thereafter, etching the portion adjacent the pillar such that at least one trench is created. The present embodiment is advantageous in that the patterning (masking) of the second magnetic layer leads to a convenient and/or efficient etching of the trench(es) in the layer.

It will be appreciated that the step of etching may further comprise creating a trench on either side of the pillar. Moreover, the step of processing may further comprise processing of a respective region of the second magnetic layer peripheral of the respective trench with respect to the pillar, such that the respective region obtains an in-plane magnetic anisotropy.

As used herein, the expression a trench, a region or a portion being created, formed or otherwise provided "on either side of the pillar" may mean that a trench/region/portion is provided on at least two sides of the pillar, as viewed in a horizontal direction (for instance corresponding to a direction of an in-plane SOT-current through the device).

A trench/region/portion may be formed to extend about the pillar. A trench/region/portion may be formed to extend partially or completely about the pillar. A trench/region/portion may accordingly be formed on either side of the pillar by two different parts of the same trench/region/portion, said two parts being formed on either side of the pillar.

According to an embodiment of the method of present invention, in case of a portion of the second magnetic layer remaining under the at least one trench after the step of etching, there is provided a step of de-magnetizing at least a part of the portion of the second magnetic layer. In other words, after the etching of one or more trenches in the second magnetic layer, there may be remnant material of the second magnetic layer under the trench(es). In the present embodiment, at least a part of this remnant material may be de-magnetized. The present embodiment is advantageous in that the portion of the second magnetic layer, subjected to a trench and a de-magnetizing process, may hereby be de-magnetized to an even higher extent.

The step of de-magnetizing may be a process step separate from, i.e. performed in addition to, the processing of said at least one region of said second magnetic layer. Alternatively, said act of processing of at least one region of said second magnetic layer peripheral of said at least one trench with respect to said pillar may include processing said at least one region and a portion of the second magnetic layer remaining under the at least one trench after the step of etching. Thereby the number of process steps may be limited.

According to an embodiment of the present invention, the method further comprises forming an electrically insulating medium in the at least one trench. For example, the trench(es) may be subjected to an insulating medium in a process. Alternatively, one or more electrically insulating media (e.g. comprising at least one oxide) may be provided in the trench(es).

According to the present invention, the step of processing of at least one region of the second magnetic layer comprises at least one of an oxidation and an irradiation of the at least one region. In other words, an oxidation and/or an irradiation of the one or more region of the second magnetic layer is conducted, such that the regions(s) obtain an in-plane magnetic anisotropy.

According to an embodiment of the present invention, the step of etching further comprises etching the stack of layers until the second magnetic layer to form a pillar, whereby a portion of the second magnetic layer extends from either side of the pillar. Furthermore, the step of de-magnetizing further comprises de-magnetizing a respective region located on either side of the pillar.

According to an embodiment of the device of the present invention, there is provided a trench on either side of the pillar and a respective second region of the second magnetic layer peripheral of the respective trench.

According to the present invention, in case of a portion of the second magnetic layer being provided under the at least one trench, at least a part of the portion of the second magnetic layer is de-magnetized.

According to an embodiment of the device of the present invention, at least one of the trenches is at least partially provided with an electrically insulating medium. For example, the electrically insulating medium may comprise one oxide. Alternatively, the electrically insulating medium may comprise a non-oxide compound, e.g. SiN.

According to an embodiment of the device of the present invention, the second magnetic layer comprises one of said at least one first portion located on either side of the pillar and one of said at least one second portion peripheral of a respective one of said at least one first portion.

According to an embodiment of the present invention, at least one of a width and a length of the device in a plane thereof is larger than the height of the stack. The present embodiment is advantageous in that the magnetization hereby may be maximal in the plane of the MTJ device. In other words, the de-magnetizing field may be maximal along a vertical axis z and minimal in the x-y-plane of the device.

Further objectives of, features of, and advantages with, the present invention will become apparent when studying the following detailed disclosure, the drawings and the appended claims. Those skilled in the art will realize that different features of the present invention can be combined to create embodiments other than those described in the following.

### Brief description of the drawings

This and other aspects of the present invention will now be described in more detail, with reference to the appended drawings showing embodiment(s) of the invention.
Figs. 1-2 are schematic views of a magnetic tunnel junction, MTJ, device according to exemplifying embodiments of the present invention, and
Fig. 3 is a schematic, top-view of an MTJ device according to an exemplifying embodiment of the present invention.

### Detailed description

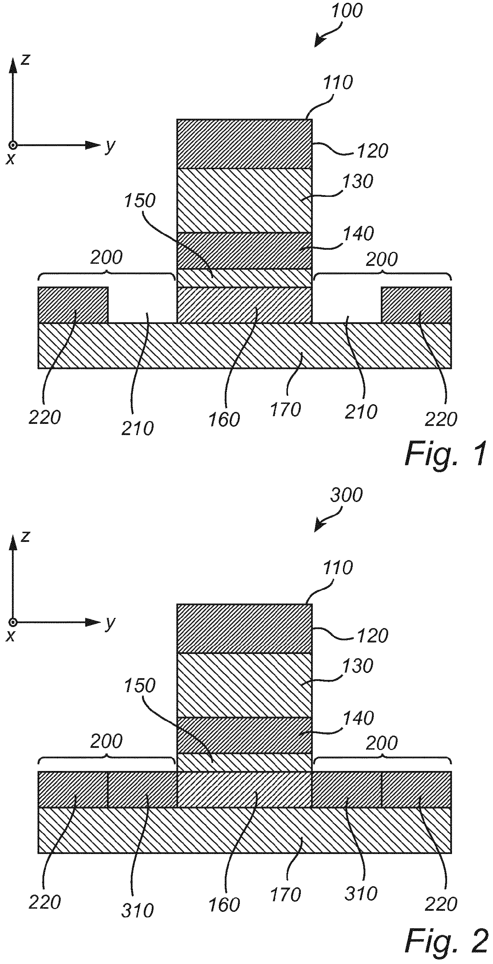

Fig. 1 is a schematic view of a magnetic tunnel junction, MTJ, device 100, according to an embodiment of the present invention. The device 100 comprises a stack of layers 110 arranged along a vertical axis z of the device 100. The structure of the device 100 is shown in a cross-section of the stacking direction of the layers 110. It should be noted that the layers 110 may extend laterally/horizontally beyond the illustrated portions. Furthermore, it should be noted that for the purpose of clarity, the various layers 110 and other features of the stacks are not drawn to scale and their relative dimensions, in particular their thickness, may differ from a physical stack.

The stack of layers 110 comprises, in a top-down direction, a hard mask 120 which is used to define the size and/or shape of the stack of layers 110, a pinning layer in the form of a synthetic antiferromagnetic (SAF) layer 130 which is used to pin a first magnetic layer 140 (also referred to as reference layer) having a fixed magnetization direction, a barrier layer 150, a second magnetic layer 160 (also referred to as free layer) being configured to switch its magnetization direction with respect to the fixed magnetization direction of the first magnetic layer 140, and a SOT-generating layer 170. It will be appreciated that the SAF layer 130 and the first 140 and second 160 magnetic layers are magnetic materials that possess perpendicular magnetic anisotropy (PMA). The SAF layer 130 may in turn comprise a plurality of layers, for example first and second magnet layers separated by a thin metal layer. The SAF layer 130 may be used to compensate the stray field generated by the first magnetic layer 140 on the second magnetic layer 160. This stray field has to be compensated for optimal performance of the MTJ device 100.

Examples of materials for the first magnetic layer 140 include Fe, Co, CoFe, FeB, CoB, and CoFeB. Ni, FePt, CoGd, CoFeGd, CoFeTb, CoTb may also be examples of materials for the first magnetic layer 140.

It will be appreciated that the first magnetic layer 140 may have a multi-layer structure including combinations of the afore-mentioned materials. The second magnetic layer 160 may include Fe, Co, FeB, CoB, CoFe, CoFeB, Ni, FePt, CoGd, CoFeGd, CoFeTb and/or CoTb and may also have a multi-layer structure including combinations of the afore-mentioned materials. The barrier layer 150 may include a layer of a dielectric material, for instance MgO, AlOx, MgAlOx or MgTiOx and may be adapted to allow electrons to tunnel between the first magnetic layer 140 and the second magnetic layer 160.

The SOT-generating layer 170 may include a layer of an electrically conducting material presenting a relatively large spin-orbit coupling. The SOT-generating layer 170 may be non-magnetic, and example materials for the SOT-generating layer 170 may include metals such as Ta, W, Pt, Pd, Ir, IrMn, PtMn, WOx, FeMn, NiMn or topological insulators such as Bi2Se3 or transition metal dichalcogenide (TMD) such as MoS2, WTe2. The SOT-generating layer 170 may also have a multi-layer structure, e.g. including a combination of any of the above-mentioned materials. The SOT-generating layer 170 may be formed with a thickness of 10 nm or less, preferably 5 nm or less, and may be formed using conventional deposition techniques such as evaporation or sputtering.

As the first magnetic layer 140 is arranged above the second magnetic layer 160, the device 100 may be referred to as a "top-pinned" MTJ device. The pinning of the first magnetic layer 140 may be achieved via ferromagnetic exchange coupling through a spacer layer with a hard magnetic layer. The spacer may include Ta, W, Mo, CoFeBTa, CoFeBW, CoBTa, FeBTa, CoBW, FeBW, FeTa, CoTa, FeW, TaW, or combinations thereof. In some cases, pinning may be achieved by coupling the first magnetic layer 140 through a spacer layer to a Co/Ru/hard magnetic layer pinning system. The hard magnetic layer may include a combination of a Co-layer and a Pt-layer, a combination of a Co-layer and a Ni-layer, a combination of a Co-layer and a Pd-layer, MnGe alloys, MnGa alloys, CoPt alloys, CoNi alloys or FePt alloys.

The first magnetic layer 140 and the SOT-generating layer 170 may be connected to a (not shown) top electrode and a bottom electrode, respectively. By conducting a current through the SOT-generating layer 170, a torque may be exerted on the magnetization of the first magnetic layer 140, and the magnetization of the first magnetic layer 140 may be switched in a relatively effective and fast way.

The hard mask 120, formed above the stack of layers 110, may include TiN, TaN, TiTaN and spin-on-carbon/spin-on-glass materials. The hard mask 120 may for instance have a rectangular or round shape as viewed in a top-down direction. The hard mask 120 may define the size and shape of the stack of layers 110 of the MTJ device 100 by etching regions of the stack of layers 110 stack which are exposed by the hard mask 120. The etching techniques may include anisotropic etch processes such as a reactive-ion-etching (RIE) process or an ion-beam-etching (IBE) process. In Fig. 1, the stack of layers 110 has been etched until the second magnetic layer 160. The hard mask 120, the synthetic antiferromagnetic layer 130, the first magnetic layer 140 and the barrier layer 150 may hereby constitute a pillar, whereby at least one portion 200 of the second magnetic layer 160 extends from either side of the pillar in a horizontal plane.

To realize the concept of providing field-free switching in (SOT)-MTJ devices, the second magnetic (free) layer 160 of the MTJ stack 110 may comprise an inner portion having an out-of-plane magnetic anisotropy and at least one outer portion having an in-plane magnetic anisotropy. The inner and outer portions of the second magnetic layer 160 may be physically separated from each other, either by one or more trenches (as shown in Fig. 1) or by one or more de-magnetized regions (as shown in Fig. 2).

By etching the stack of layers 110 adjacent the pillar of the MTJ device 100 in Fig. 1, at least one trench 210 may be created in the second magnetic layer 160. In the device 100, at least one first region of the portion(s) 200 of the second magnetic layer 160 extending from the pillar comprises a trench 210 adjacent and on either side of the pillar. A trench may be formed to extend completely about the pillar. For a pillar with a rectangular cross section, trenches or trench parts may accordingly be formed on all sides of the pillar. For a pillar with a round cross section a single round trench extending about the pillar may be formed. It will be appreciated that the trench(es) 210, comprising perpendicular edges, are schematically shown for reasons of simplicity. In other words, it will be appreciated that the shapes of the trenches 210 obtained after etching may be highly irregular. The properties of the trench(es) 210 such as width, depth, length, profile, etc., may be relatively difficult to control during the etching process. However, examples of the width and depth of the trench(es) 210 may be approximately 4 nm.

Furthermore, by a processing of the portion(s) 200 of the second magnetic layer 160, at least one second region 220 of the portion(s) 200 may obtain an in-plane magnetic anisotropy. The processing of the portion(s) 200 may include oxidation, e.g. by subjecting the one or more portions 200 to an O₂-plasma. For example, the processing may be performed in situ an etching machine, and the plasma is usually created from an oxygen gas. The portion(s) 200 may be subjected to the plasma for a predetermined period of time, which will influence the penetration depth of the oxygen into the material of the portion(s) 200.

Alternatively, or in combination herewith, the processing may include (ion) irradiation of the portion(s) 200. For example, the processing may be performed by accelerating ions (e.g. Gd ions) which penetrate into the material of the portions(s) 200.

In the MTJ device 100 in Fig. 1, there is provided at least one second region 220 peripheral of the at least one trench 210 with respect to the pillar in the x-direction, which has an in-plane magnetic anisotropy. It will be appreciated that the thickness of the second region(s) 220 may be thicker or thinner than the second magnetic layer 160.

Furthermore, after the etching of one or more trenches 210 of the second magnetic layer 160 of the MTJ device 100, there may be remnant material of the second magnetic layer 160 under the trench(es) 210. In such situations, it may be desirable to de-magnetize at least a part of this remnant material such that a (completely) de-magnetized region is obtained. It will be appreciated that O₂-plasma may be used in the de-magnetization process, and the remnant material may be completely oxidized. Remnant material in the trench may in fact be de-magnetized during an O₂-plasma processing of the portion(s) 200.

Alternatively, or in combination herewith, an electrically insulating medium may be provided to the trench(es) 210.. The electrically insulating medium may comprise a non-oxide compound, e.g. SiN.

Fig. 2 is a schematic view of a magnetic tunnel junction, MTJ, device 300, according to an alternative embodiment of the MTJ device 100 of Fig. 1. The device 300 comprises a stack 110 of layers analogously to the stack of layers 110 of device 100, and it is hereby referred to Fig. 1 for a more detailed description of the individual layers. However, instead of having one or more trenches, the second magnetic layer 160 comprises portions 310 located adjacent and on either side of the pillar, wherein the portions 310 are at least partially de-magnetized. It will be appreciated that the effect of providing de-magnetized portions 310 in the MTJ device 300 may be comparable to that of providing trenches according to the MTJ device 100 of Fig. 1, as both embodiments provide a de-magnetized region and/or separation between the inner and outer portions of the second magnetic layer of the MTJ device 100, 300. Alternatively, the portions 310 may comprise one or more electrically insulating media. For example, the portions 310 may comprise an oxide or a non-oxide compound, such as SiN. The de-magnetized portions 310 may be created by subjecting the region of the second magnetic layer 160 adjacent to the pillar to an O₂-plasma. The de-magnetization step may be performed after the above-described processing (e.g. by oxidation or irradiation) for forming the in-plane magnetization portion 220 of the second magnetic layer 160. During the de-magnetization step, the portions of the second magnetic layer 160 which are not to be de-magnetized (i.e. portions 220) may be masked to be protected from e.g. the O₂-plasma.

In a variation of the method and structure described in conjunction with Fig. 2, the stack of layers 110 may be etched until only the barrier layer 150, or only the first magnetic layer 140. Accordingly, at least the hard mask 120, the pinning layer / SAF layer 130 may constitute a pillar. Accordingly, the second magnetic layer 160, the barrier layer 150 and possibly also the first magnetic layer 140 may comprise respective portions located outside of the pillar, as viewed in the horizontal planes defined by the respective layers. Still, portions 220 of the second magnetic layer 160 presenting an in-plane magnetization, and de-magnetized portions 310 of the second magnetic layer 160 may be created by subjecting these portions to processing and de-magnetization steps, as described above. If the etch has been stopped already at the first magnetic layer 140, also the portions of the first magnetic layer 140 exposed by the pillar, and located above the portions 310, may be provided with a peripheral portion with an in-plane magnetization and a de-magnetized portion adjacent to the pillar.

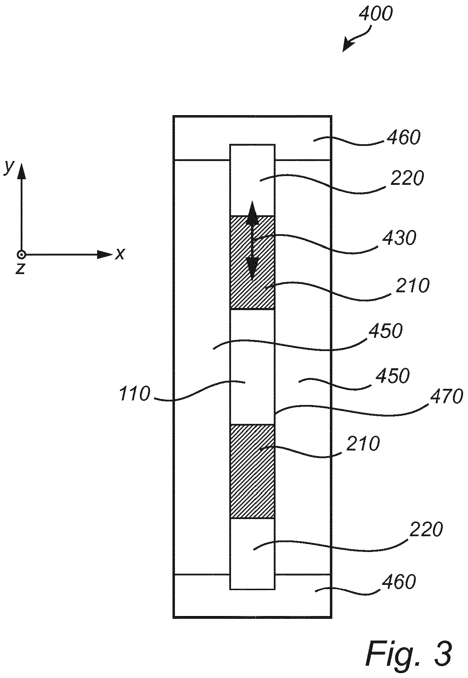

Fig. 3 is a schematic, top-view of an MTJ device 400 according to an embodiment of the MTJ device 100 of Fig. 1 or 300 of Fig. 2. Region 470 may comprise the stack of layers 110 and the SOT-generating layer 170. Between the stack of layers 110 and the two second regions 220 having an in-plane magnetic anisotropy, there may be provided trenches 210 according to Fig. 1 or portions 310 according to Fig. 2. Furthermore, a portion of the first magnetic layer 140 and/or the barrier layer 150 may be provided on the at least one second region 220, whereby said portion of the first magnetic layer 140 has been processed to be de-magnetized and insulating. The arrow 430 indicates the in-plane current of the MTJ device 400, the region 460 indicates the bottom electrode and region 450 indicates an insulating medium. The device 400 elongates in the direction of the in-plane current 430 (i.e. the y-direction), and the length of the device 400 in the y-direction may be larger than the height (i.e. in the z-direction) of the stack of the device 400. Furthermore, the length of the device 400 may be larger than the width (i.e. in the x-direction) of the stack of the device 400. It will be appreciated that this shape of the device 400 may create a de-magnetizing field which may orient the in-plane magnetic (shape) anisotropy along the direction of the current 430. Hence, the shape anisotropy will tend to naturally align the in-plane magnetization along the elongated axis. The de-magnetizing field should be larger in the x-direction than in the y-direction. In other words, the longitudinal direction should be larger than the transverse direction. Hence, there is an equivalency of applying a field along the longitudinal direction and forcing the magnetization to align with the longitudinal direction

The person skilled in the art realizes that the present invention by no means is limited to the preferred embodiments described above. On the contrary, many modifications and variations are possible within the scope of the appended claims. For example, it will be appreciated that the figures are merely schematic views of MTJ devices according to embodiments of the present invention. Hence, any layers of the MTJ devices 100, 300 may have different dimensions, shapes and/or sizes than those depicted and/or described. For example, one or more layers may be thicker or thinner than what is exemplified in the figures, the trench(es) may have other shapes, depths, etc., than that/those depicted. Furthermore, it will be appreciated that the techniques related to the masking, patterning and/or etching, may be different from those disclosed.

## Claims

1. A method for forming a magnetic tunnel junction, MTJ, device (100), comprising:
providing a stack of layers (110), at least comprising, in a top-down direction,
a first magnetic layer (140) having a fixed magnetization direction
a barrier layer (150), and
a second magnetic layer (160) being configured to switch its magnetization direction with respect to the fixed magnetization direction of said first magnetic layer, the second magnetic layer having an out-of-plane magnetic anisotropy, etching said stack of layers such that a pillar is formed and such that at least one trench (210) is created in said second magnetic layer adjacent said pillar, and processing of at least one region (200) of said second magnetic layer peripheral of said at least one trench with respect to said pillar, wherein said step of processing comprises at least one of an oxidation and an irradiation of said at least one region, such that said at least one region obtains an in-plane magnetic anisotropy.

2. The method according to claim 1, wherein the step of etching further comprises
etching said stack of layers until said second magnetic layer to form a pillar, whereby a portion (200) of said second magnetic layer extends from said pillar in a horizontal plane,
patterning the portion of said second magnetic layer and, thereafter, etching said portion adjacent said pillar such that at least one trench (210) is created

3. The method according to claim 1 or 2, wherein the step of etching further comprises creating a trench (210) on either side of said pillar, and wherein said step of processing further comprises processing of a respective region (220) of said second magnetic layer peripheral of the respective trench with respect to said pillar, such that said respective region obtains an in-plane magnetic anisotropy.

4. The method according to any one of the preceding claims, further comprising, in case of a portion of said second magnetic layer remaining under said at least one trench after said step of etching, de-magnetizing at least a part of said portion of said second magnetic layer.

5. The method according to any one of the preceding claims, further comprising forming an electrically insulating medium in said at least one trench.

6. A method for forming a magnetic tunnel junction, MTJ, device (300), comprising
providing a stack of layers (110) at least comprising, in a top-down direction,
a first magnetic layer (140) having a fixed magnetization direction
a barrier layer (150), and
a second magnetic layer (160) being configured to switch its magnetization direction with respect to the fixed magnetization direction of said first magnetic layer, the second magnetic layer having an out-of-plane magnetic anisotropy, the stack of layers further including a pinning layer (130) arranged above the first magnetic layer for fixing the magnetization direction of the first magnetic layer, the method further comprising:
etching said stack of layers, at least until said first magnetic layer, to form a pillar,
processing a portion (310) of said second magnetic layer extending outside said pillar in a horizontal plane, wherein said step of processing comprises at least one of an oxidation and an irradiation of said at least one region, such that said portion obtains an in-plane magnetic anisotropy, and
de-magnetizing, of the portion of said second magnetic layer, at least one region located adjacent said pillar in a horizontal plane.

7. The method according to claim 6, wherein the step of de-magnetizing further comprises de-magnetizing a respective region (310) located on either side of said pillar

8. A magnetic tunnel junction, MTJ, device (100), comprising a stack of layers (110), at least comprising, in a top-down direction,
a first magnetic layer (140) having a fixed magnetization direction
a barrier layer (150), and
a second magnetic layer (160) being configured to switch its magnetization direction with respect to the fixed magnetization direction of said first magnetic layer, the second magnetic layer having an out-of-plane magnetic anisotropy,
wherein at least said first magnetic layer and said barrier layer constitute a pillar, and wherein a portion of said second magnetic layer extends from said pillar in a horizontal plane,
wherein at least one first region (200) of the portion of said second magnetic layer comprises at least one trench (210) adjacent said pillar, wherein, in case of a portion of said second magnetic layer being provided under said at least one trench, at least a part of said portion of said second magnetic layer is de-magnetized, and
wherein, of the portion of said second magnetic layer, at least one second region (220) peripheral of said at least one trench with respect to said pillar, have an in-plane magnetic anisotropy.

9. The device according to claim 8, comprising a trench on either side of said pillar and a respective second region peripheral of the respective trench.

10. The device according to claim 8 or 9, wherein at least one of said trenches is at least partially provided with an electrically insulating medium.

11. A magnetic tunnel junction, MTJ, device (300), comprising a stack of layers (110), at least comprising, in a top-down direction,
a first magnetic layer (140) having a fixed magnetization direction
a barrier layer, layer (150), and
a second magnetic layer (160) being configured to switch its magnetization direction with respect to the fixed magnetization direction of said first magnetic layer, the second magnetic layer having an out-of-plane magnetic anisotropy, the stack of layers further including a pinning layer (130) arranged above the first magnetic layer for fixing the magnetization direction of the first magnetic layer,
wherein at least said pinning layer constitutes a pillar,
wherein said second magnetic layer comprises at least one first portion (310) located outside said pillar, as viewed in a horizontal plane, said at least one first portion being de-magnetized, and
wherein said second magnetic layer comprises at least one second portion (220) located peripheral of said at least one first portion with respect to said pillar, said at least one second portion having an in-plane magnetic anisotropy.

12. The device according to claim 11, wherein said second magnetic layer comprises one of said at least one first portion located on either side of said pillar and one of said at least one second portion peripheral of a respective one of said at least one first portion.

13. The device according to any one of claims 8-12, wherein at least one of a width and a length of said device in a plane thereof is larger than the height of said stack.

## Patentansprüche

1. Verfahren zum Bilden einer Magnettunnelübergangs-, MTJ, Vorrichtung (100), umfassend folgende Schritte:
Bereitstellen eines Schichtstapels (110), der von oben nach unten mindestens Folgendes umfasst
eine erste Magnetschicht (140), die eine feste Magnetisierungsrichtung aufweist,
eine Sperrschicht (150), und
eine zweite Magnetschicht (160), die konfiguriert ist, um ihre Magnetisierungsrichtung in Bezug auf die feste Magnetisierungsrichtung der ersten Magnetschicht zu wechseln, wobei die zweite Magnetschicht eine magnetische Anisotropie außerhalb der Ebene aufweist,
Ätzen des Schichtstapels, so dass sich eine Säule bildet, und so dass mindestens ein Graben (210) in der zweiten Magnetschicht neben der Säule entsteht, und
Verarbeiten mindestens einer Region (200) der zweiten Magnetschicht an der Außenseite des mindestens einen Grabens in Bezug auf die Säule, wobei der Schritt des Verarbeitens mindestens eine von einer Oxidation und einer Bestrahlung der mindestens einen Region umfasst, so dass die mindestens eine Region eine magnetische Anisotropie innerhalb der Ebene erhält.

2. Verfahren nach Anspruch 1, wobei der Schritt des Ätzens ferner Folgendes umfasst
Ätzen des Schichtstapels bis zur zweiten Magnetschicht, um eine Säule zu bilden, wodurch sich ein Abschnitt (200) der zweiten Magnetschicht von der Säule aus in einer horizontalen Ebene erstreckt,
Strukturieren des Abschnitts der zweiten Magnetschicht, und danach Ätzen des Abschnitts neben der Säule, so dass mindestens ein Graben (210) entsteht.

3. Verfahren nach Anspruch 1 oder 2, wobei der Schritt des Ätzens ferner das Erstellen eines Grabens (210) auf beiden Seiten der Säule umfasst, und wobei der Schritt des Verarbeitens ferner das Verarbeiten einer jeweiligen Region (220) der zweiten Magnetschicht an der Außenfläche des jeweiligen Grabens in Bezug auf die Säule umfasst, so dass die jeweilige Region eine magnetische Anisotropie innerhalb der Ebene erhält.

4. Verfahren nach einem der vorhergehenden Ansprüche, ferner umfassend, falls nach dem Schritt des Ätzens ein Abschnitt der zweiten Magnetschicht unter dem mindestens einen Graben verbleibt, das Entmagnetisieren mindestens eines Teils des Abschnitts der zweiten Magnetschicht.

5. Verfahren nach einem der vorhergehenden Ansprüche, ferner umfassend das Bilden eines elektrisch isolierenden Mediums in dem mindestens einen Graben.

6. Verfahren zum Bilden einer Magnettunnelübergangs-, MTJ, Vorrichtung (300), umfassend folgende Schritte
Bereitstellen eines Schichtstapels (110), der von oben nach unten mindestens Folgendes umfasst
eine erste Magnetschicht (140), die eine feste Magnetisierungsrichtung aufweist,
eine Sperrschicht (150), und
eine zweite Magnetschicht (160), die konfiguriert ist, um ihre Magnetisierungsrichtung in Bezug auf die feste Magnetisierungsrichtung der ersten Magnetschicht zu wechseln, wobei die zweite Magnetschicht eine magnetische Anisotropie außerhalb der Ebene aufweist,
wobei der Schichtstapel ferner eine Pinning-Schicht (130) umfasst, die über der ersten Magnetschicht angeordnet ist, um die Magnetisierungsrichtung der ersten Magnetschicht festzulegen,
wobei das Verfahren ferner folgende Schritte umfasst:
Ätzen des Schichtstapels mindestens bis zur ersten Magnetschicht, um eine Säule zu bilden,
Verarbeiten eines Abschnitts (310) der zweiten Magnetschicht, der sich außerhalb der Säule in einer horizontalen Ebene erstreckt, wobei der Schritt des Verarbeitens mindestens eine von einer Oxidation und einer Bestrahlung der mindestens einen Region umfasst, so dass der Abschnitt eine magnetische Anisotropie innerhalb der Ebene erhält, und
Entmagnetisieren des Abschnitts der zweiten Magnetschicht, wobei sich mindestens eine Region neben der Säule in einer horizontalen Ebene befindet.

7. Verfahren nach Anspruch 6, wobei der Schritt des Entmagnetisierens ferner das Entmagnetisieren einer jeweiligen Region (310), die sich auf beiden Seiten der Säule befindet, umfasst.

8. Magnettunnelübergangs-, MTJ, Vorrichtung (100), umfassend
einen Schichtstapel (110), der von oben nach unten mindestens Folgendes umfasst
eine erste Magnetschicht (140), die eine feste Magnetisierungsrichtung aufweist,
eine Sperrschicht (150), und
eine zweite Magnetschicht (160), die konfiguriert ist, um ihre Magnetisierungsrichtung in Bezug auf die feste Magnetisierungsrichtung der ersten Magnetschicht zu wechseln, wobei die zweite Magnetschicht eine magnetische Anisotropie außerhalb der Ebene aufweist,
wobei mindestens die erste Magnetschicht und die Sperrschicht eine Säule bilden, und wobei sich ein Abschnitt der zweiten Magnetschicht von der Säule in einer horizontalen Ebene erstreckt,
wobei mindestens eine erste Region (200) des Abschnitts der zweiten Magnetschicht mindestens einen Graben (210) umfasst, der neben der Säule liegt, wobei, falls ein Abschnitt der zweiten Magnetschicht unter dem mindestens einen Graben bereitgestellt wird, mindestens ein Teil des Abschnitts der zweiten Magnetschicht entmagnetisiert wird, und
wobei von dem Abschnitt der zweiten Magnetschicht mindestens eine zweite Region (220) an der Außenfläche des mindestens einen Grabens in Bezug auf die Säule eine magnetische Anisotropie innerhalb der Ebene aufweist.

9. Vorrichtung nach Anspruch 8, umfassend einen Graben auf beiden Seiten der Säule und eine jeweilige zweite Region an der Außenfläche des jeweiligen Grabens.

10. Vorrichtung nach Anspruch 8 oder 9, wobei mindestens einer der Gräben mindestens teilweise mit einem elektrisch isolierenden Medium versehen ist.

11. Magnettunnelübergangs-, MTJ, Vorrichtung (300), umfassend einen Schichtstapel (110), der von oben nach unten mindestens Folgendes umfasst
eine erste Magnetschicht (140), die eine feste Magnetisierungsrichtung aufweist,
eine Sperrschicht (150), und
eine zweite Magnetschicht (160), die konfiguriert ist, um ihre Magnetisierungsrichtung in Bezug auf die feste Magnetisierungsrichtung der ersten Magnetschicht zu wechseln, wobei die zweite Magnetschicht eine magnetische Anisotropie außerhalb der Ebene aufweist,
wobei der Schichtstapel ferner eine Pinning-Schicht (130) umfasst, die über der ersten Magnetschicht angeordnet ist, um die Magnetisierungsrichtung der ersten Magnetschicht festzulegen,
wobei mindestens die Pinning-Schicht eine Säule bildet,
wobei die zweite Magnetschicht mindestens einen ersten Abschnitt (310) umfasst, der sich in einer horizontalen Ebene gesehen außerhalb der Säule befindet, wobei der mindestens eine erste Abschnitt entmagnetisiert ist, und
wobei die zweite Magnetschicht mindestens einen zweiten Abschnitt (220) umfasst, der sich an der Außenfläche des mindestens einen ersten Abschnitts in Bezug auf die Säule befindet, wobei der mindestens eine zweite Abschnitt eine magnetische Anisotropie innerhalb der Ebene aufweist.

12. Vorrichtung nach Anspruch 11, wobei die zweite Magnetschicht einen von dem mindestens einen ersten Abschnitt, der sich auf beiden Seiten der Säule befindet, und einen von dem mindestens einen zweiten Abschnitt, der sich an der Außenfläche eines jeweiligen des mindestens einen ersten Abschnitts befindet, umfasst.

13. Vorrichtung nach einem der Ansprüche 8 bis 12, wobei mindestens eine von einer Breite und einer Länge der Vorrichtung in einer Ebene derselben größer als die Höhe des Stapels ist.

## Revendications

1. Procédé pour former un dispositif de jonction à effet tunnel magnétique, MTJ, (100) comprenant :
la fourniture d'une pile de couches (110) comprenant au moins, dans une direction du haut vers le bas,
une première couche magnétique (140) ayant une direction de magnétisation fixe,
une couche barrière (150), et
une deuxième couche magnétique (160) configurée pour commuter sa direction de magnétisation par rapport à la direction de magnétisation fixe de ladite première couche magnétique, la deuxième couche magnétique ayant une anisotropie magnétique hors plan,
la gravure de ladite pile de couches de sorte qu'un pilier est formé et de sorte qu'au moins une tranchée (210) est créée dans ladite deuxième couche magnétique adjacente audit pilier, et
le traitement d'au moins une zone (200) de ladite deuxième couche magnétique en périphérie de ladite au moins une tranchée par rapport audit pilier, dans lequel ladite étape de traitement comprend au moins l'une parmi une oxydation et une irradiation de ladite au moins une zone, de sorte que ladite au moins une zone obtient une anisotropie magnétique dans le plan.

2. Procédé selon la revendication 1, dans lequel l'étape de gravure comprend en outre :
la gravure de ladite pile de couches jusqu'à ladite deuxième couche magnétique pour former un pilier, moyennant quoi une portion (200) de ladite deuxième couche magnétique s'étend à partir dudit pilier dans un plan horizontal,
la structuration de la portion de ladite deuxième couche magnétique, et ensuite, la gravure de ladite portion adjacente audit pilier de sorte qu'au moins une tranchée (210) est créée.

3. Procédé selon la revendication 1 ou 2, dans lequel l'étape de gravure comprend en outre la création d'une tranchée (210) de chaque côté dudit pilier, et dans lequel ladite étape de traitement comprend en outre le traitement d'une zone respective (220) de ladite deuxième couche magnétique en périphérie de la tranchée respective par rapport audit pilier, de sorte que ladite zone respective obtient une anisotropie magnétique dans le plan.

4. Procédé selon l'une quelconque des revendications précédentes, comprenant en outre, dans le cas d'une portion de ladite deuxième couche magnétique subsistant sous ladite au moins une tranchée après ladite étape de gravure, la démagnétisation d'au moins une partie de ladite portion de ladite deuxième couche magnétique.

5. Procédé selon l'une quelconque des revendications précédentes, comprenant en outre la formation d'un milieu isolant électriquement dans ladite au moins une tranchée.

6. Procédé pour former un dispositif de jonction à effet tunnel magnétique, MTJ, (300) comprenant :
la fourniture d'une pile de couches (110), comprenant au moins, dans une direction du haut vers le bas,
une première couche magnétique (140) ayant une direction de magnétisation fixe,
une couche barrière (150), et
une deuxième couche magnétique (160) configurée pour commuter sa direction de magnétisation par rapport à la direction de magnétisation fixe de ladite première couche magnétique, la deuxième couche magnétique ayant une anisotropie magnétique hors plan,
la pile de couches comprenant en outre une couche de fixation (130) disposée au-dessus de la première couche magnétique pour fixer la direction de magnétisation de la première couche magnétique, le procédé comprenant en outre :
la gravure de ladite pile de couches, au moins jusqu'à ladite première couche magnétique, pour former un pilier,
le traitement d'une portion (310) de ladite deuxième couche magnétique s'étendant à l'extérieur dudit pilier dans un plan horizontal, dans lequel ladite étape de traitement comprend au moins l'une parmi une oxydation et une irradiation de ladite au moins une zone de sorte que ladite portion obtient une anisotropie magnétique dans le plan, et
la démagnétisation, de la portion de ladite deuxième couche magnétique, d'au moins une zone située de façon adjacente audit pilier dans un plan horizontal.

7. Procédé selon la revendication 6, dans lequel l'étape de démagnétisation comprend en outre la démagnétisation d'une zone respective (310) située de chaque côté dudit pilier.

8. Dispositif de jonction à effet tunnel magnétique, MTJ, (100), comprenant :
une pile de couches (110), comprenant au moins, dans une direction du haut vers le bas,
une première couche magnétique (140) ayant une direction de magnétisation fixe,
une couche barrière (150), et
une deuxième couche magnétique (160) configurée pour commuter sa direction de magnétisation par rapport à la direction de magnétisation fixe de ladite première couche magnétique, la deuxième couche magnétique ayant une anisotropie magnétique hors plan,
dans lequel au moins ladite première couche magnétique et ladite couche barrière constituent un pilier, et dans lequel une portion de ladite deuxième couche magnétique s'étend à partir dudit pilier dans un plan horizontal,
dans lequel au moins une première zone (200) de la portion de ladite deuxième couche magnétique comprend au moins une tranchée (210) adjacente audit pilier, dans lequel, dans le cas d'une portion de ladite deuxième couche magnétique fournie sous ladite au moins une tranchée, au moins une partie de ladite portion de ladite deuxième couche magnétique est démagnétisée, et
dans lequel, de la portion de ladite deuxième couche magnétique, au moins une deuxième zone (220) en périphérie de ladite au moins une tranchée par rapport audit pilier a une anisotropie magnétique dans le plan.

9. Dispositif selon la revendication 8, comprenant une tranchée de chaque côté dudit pilier et une deuxième zone respective en périphérie de la tranchée respective.

10. Dispositif selon la revendication 8 ou 9, dans lequel au moins l'une desdites tranchées est au moins partiellement dotée d'un milieu isolant électriquement.

11. Dispositif de jonction à effet tunnel magnétique, MTJ, (300) comprenant :
une pile de couches (110), comprenant au moins, dans une direction du haut vers le bas,
une première couche magnétique (140) ayant une direction de magnétisation fixe,
une couche barrière (150), et
une deuxième couche magnétique (160) configurée pour commuter sa direction de magnétisation par rapport à la direction de magnétisation fixe de ladite première couche magnétique, la deuxième couche magnétique ayant une anisotropie magnétique hors plan,
la pile de couches comprenant en outre une couche de fixation (130) disposée au-dessus de la première couche magnétique pour fixer la direction de magnétisation de la première couche magnétique,
dans lequel au moins ladite couche de fixation constitue un pilier,
dans lequel ladite deuxième couche magnétique comprend au moins une première portion (310) située à l'extérieur dudit pilier, en vue dans un plan horizontal, ladite au moins une première portion étant démagnétisée, et
dans lequel ladite deuxième couche magnétique comprend au moins une deuxième portion (220) située en périphérie de ladite au moins une première portion par rapport audit pilier, ladite au moins une deuxième portion ayant une anisotropie magnétique dans le plan.

12. Dispositif selon la revendication 11, dans lequel ladite deuxième couche magnétique comprend l'une parmi ladite au moins une première portion située de chaque côté dudit pilier et l'une parmi ladite au moins une deuxième portion en périphérie d'une portion respective de ladite au moins une première portion.

13. Dispositif selon l'une quelconque des revendications 8-12, dans lequel au moins l'une parmi une largeur et une longueur dudit dispositif, en vue en plan de celui-ci, est supérieure à la hauteur de ladite pile.
